# EUROPEAN PATENT APPLICATION

(11) **EP 4 342 920 A1**
(43) Date of publication of application: **27.03.2024**
(21) Application number: 22804500.1
(22) Date of filing: 21.04.2022
(51) Int. Cl.: C08F 230/08, C08F 220/12, C08F 283/01, C08F 290/06, C09D 143/04, G03F 7/004, G03F 7/075

(54) **SILICONE CHAIN-CONTAINING POLYMER, COATING COMPOSITION, RESIST COMPOSITION AND ARTICLE**

(30) Priority: 18.05.2021 JP 2021083777
(71) Applicant: DIC CORPORATION, Itabashi-ku Tokyo 174-8520 (JP)
(72) Inventor: HATASE, Masaki, Ichihara-shi, Chiba 290-8585 (JP); SHIMIZU, Ryohei, Ichihara-shi, Chiba 290-8585 (JP); SUZUKI, Hideya, Ichihara-shi, Chiba 290-8585 (JP)
(74) Representative: Kraus & Lederer PartGmbB
(86) International application number: PCT/JP2022/018351
(87) International publication number: WO 2022/244586

(57) **Abstract**

Provided is a silicone chain-containing polymer functioning as a leveling agent giving high smoothness to a coating film. Specifically, provided is a silicone chain-containing polymer containing, as a polymeric component, at least a polymerizable monomer (1) having a group represented by General Formula (A) below and a polymerizable monomer (2) having a group containing a polyester chain:
wherein R¹¹ are each independently a C₁₋₆ alkyl group or a group represented by -OSi(R¹⁴)₃ (R¹⁴ are each independently a C₁₋₃ alkyl group), R¹² are each independently a C₁₋₆ alkyl group, R¹³ is a C₁₋₆ alkyl group, and x is an integer of 0 or more.

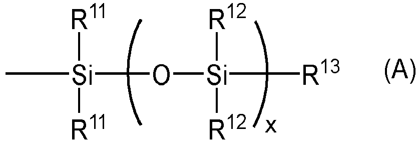

## Description

### Technical Field

The present invention relates to a silicone chain-containing polymer, a coating composition, a resist composition, and an article.

### Background Art

Leveling agents are added in order to smooth coating films obtained by applying coating compositions such as paint compositions and resist compositions. Specifically, by adding a leveling agent to a coating composition, the leveling agent is oriented on the surface of a coating film and lowers the surface tension of the coating film, resulting in a smoothing effect on the resulting coating film. The coating film with the smooth surface can improve the occurrence of crawling and unevenness.

Leveling agents are used for, for example, paints for cars, and paint compositions containing leveling agents can impart high smoothness to the surface of coating films to be obtained and can add gloss to car appearances.

As leveling agents for use in paints for cars, silicone-based leveling agents have been developed (PTL 1 and PTL 2).

Leveling agents have a wide variety of uses and are also used for, for example, color resist compositions used for the production of color filters for liquid crystal displays. The manufacture of color filters generally includes steps of applying a color resist composition onto a glass substrate by a method of application such as spin coating or slit coating, exposing a coating film after being dried using a mask, and then performing development to form a colored pattern. In this case, if the coating film has poor smoothness or unevenness in film thickness, or if there is application unevenness, crawling, or the like, pixel color unevenness may occur.

By adding the leveling agent to the color resist composition, the smoothness of the coating film to be obtained improves, and the surfaces of red (R), green (G), and blue (B) pixels and a black matrix (BM) formed between these pixels can show high smoothness, and a color filter with less color unevenness can be produced.

### Citation List

### Patent Literature

PTL 1: Japanese Unexamined Patent Application Publication No. 2003-226834
PTL 2: Japanese Unexamined Patent Application Publication No. 2018-199765

### Summary of Invention

### Technical Problem

The silicone-based leveling agent produces a leveling effect by the silicone-based leveling agent segregating on the surface (an interface with air) due to the low surface tension of its silicone chain, but the surface segregation performance of the silicone-based leveling agents disclosed in PTL 1 and PTL 2 is not sufficient, and thus the obtained leveling effect is not sufficient.

An object of the present invention is to provide a silicone-chain containing polymer functioning as a leveling agent giving high smoothness to a coating film.

### Solution to Problem

The inventors of the present invention have conducted earnest study in order to achieve the above object to find that a polymer containing, as a polymeric component, a polymerizable monomer having a specific silicon chain and a polymerizable monomer having a specific ester chain exhibits high leveling properties capable of standing up to even resist uses, and have completed the present invention.

Specifically, the present invention relates to a silicone chain-containing polymer containing, as a polymeric component, at least a polymerizable monomer (1) having a silicone chain represented by General Formula (A) below and a polymerizable monomer (2) having a polyester chain: 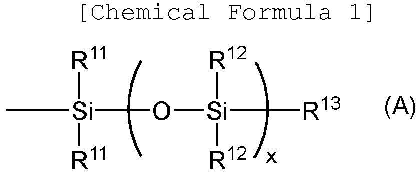 in General Formula (A) above,
R¹¹ are each independently a C₁₋₆ alkyl group or a group represented by -OSi (R¹⁴)₃ (R¹⁴ are each independently a C₁₋₃ alkyl group),
R¹² are each independently a C₁₋₆ alkyl group,
R¹³ is a C₁₋₆ alkyl group, and
x is an integer of 0 or more.

### Advantageous Effects of Invention

The present invention can provide a silicone chain-containing polymer functioning as a leveling agent giving high smoothness to a coating film.

### Description of Embodiments

The following describes one embodiment of the present invention. The present invention is not limited to the following embodiment and may be implemented with changes added as appropriate to the extent that the effects of the present invention are not impaired.

In the specification of the present application, "(meth)acrylate" means one or both of acrylate and methacrylate.

### [Silicone Chain-Containing Polymer]

The silicone chain-containing polymer of the present invention (hereinafter, may be referred to simply as "the polymer of the present invention") is a polymer containing, as a polymeric component, at least a polymerizable monomer (1) having a group represented by General Formula (A) below and a polymerizable monomer (2) having a group containing a polyester chain. 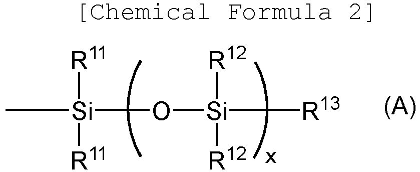 in General Formula (A) above,
R11 are each independently a C₁₋₆ alkyl group or a group represented by -OSi(R14)3 (R14 are each independently a C₁₋₃ alkyl group),
R12 are each independently a C₁₋₆ alkyl group,
R13 is a C₁₋₆ alkyl group, and
x is an integer of 0 or more.

In the polymer of the present invention, the group containing a polyester chain is slightly less compatible with, for example, binder resins and solvents contained in a coating composition than a group having an alkylene chain and a group having an alkyleneoxy chain are. Thus, it is thought that when the coating composition contains the polymer of the present invention, the polymer of the present invention is likely to segregate on the surface of a coating film of the coating composition.

In the present invention, the "polymerizable monomer" means a compound having a polymerizable unsaturated group, and examples of the polymerizable unsaturated group of the polymerizable monomer (1) and the polymerizable monomer (2) include C=C-containing groups such as a (meth)acryloyl group, a (meth)acryloyloxy group, a (meth)acryloylamino group, a vinyl ether group, an allyl group, a styryl group, and a maleimide group. Among these, a (meth)acryloyl group and a (meth)acryloyloxy group are preferred because of their raw material availability and good polymerization reactivity.

The polymerizable monomer may have one polymerizable unsaturated group or two or more.

In the present invention, the "polymeric component" means a component forming the polymer and does not include solvents, polymerization initiators, or the like, which do not form the polymer.

In General Formula (A) above, R¹¹ is preferably a methyl group or a trimethylsiloxy group, and R¹² and R¹³ are each preferably a methyl group.

In General Formula (A) above, the number average of x is preferably an integer in a range of 1 to 200, more preferably an integer in a range of 1 to 150, even more preferably an integer in a range of 1 to 75, and particularly preferably an integer in a range of 1 to 20.

The polymerizable monomer (1) is only required to have at least the group represented by General Formula (A) above and is preferably a compound represented by General Formula (1-1) below. 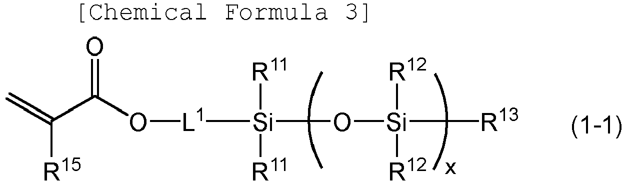 in General Formula (1-1) above,
R¹¹, R¹², R¹³, and x are the same as R¹¹, R¹², R¹³, and x in General Formula (A) above, respectively,
R¹⁵ is a hydrogen atom or a methyl group, and
L¹ is a divalent organic group or a single bond.

The divalent organic group of L¹ is preferably a single bond, a C₁₋₅₀ alkylene group, or a C₁₋₅₀ alkyleneoxy group.

Examples of the C₁₋₅₀ alkylene group of L¹ include a methylene group, an ethylene group, a n-propylene group, a n-butylene group, a n-pentylene group, a n-hexylene group, a n-heptylene group, a n-octylene group, a n-nonylene group, a n-decylene group, a n-dodecylene group, an isopropylene group, a 2-methylpropylene group, a 2-methylhexylene group, and a tetramethylethylene group.

The C₁₋₅₀ alkylene group of L¹ is preferably a C₁₋₁₅ alkylene group, more preferably a C₁₋₅ alkylene group, and even more preferably a methylene group, an ethylene group, a n-propylene group, or an isopropylene group.

The C₁₋₅₀ alkyleneoxy group of L¹ is, for example, a group in which one -CH₂- of the alkylene group is replaced by -O-.

The C₁₋₅₀ alkyleneoxy group of L¹ is preferably a C₁₋₁₅ alkyleneoxy group, more preferably a C₁₋₈ alkyleneoxy group, even more preferably a methyleneoxy group, an ethyleneoxy group, a propyleneoxy group, an oxytrimethylene group, a butyleneoxy group, an oxytetramethylene group, a pentyleneoxy group, a heptyleneoxy group, or an octyleneoxy group.

When the divalent organic group of L¹ is the C₁₋₅₀ alkylene group or the C₁₋₅₀ alkyleneoxy group, in these divalent organic groups, part of -CH₂- may be replaced by a carbonyl group (-C(=O)-), a phenylene group, an amide bond, or a urethane bond, and further, a carbon atom may have a substituent such as a hydroxy group.

The polymerizable monomer (1) can be produced by known methods, or commercially available products may be used.

Specific examples of the polymerizable monomer (1) include α-(3-methacryloyloxy)propyl polydimethylsiloxane and 3-(methacryloyloxy)propyl tris(trimethylsiloxy)silane.

The group containing a polyester chain of the polymerizable monomer (2) is preferably a group represented by General Formula (B-1) below or a group represented by General Formula (B-2) below. 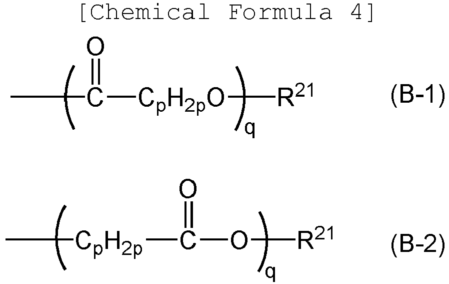 in General Formulae (B-1) and (B-2) above,
R²¹ is a hydrogen atom, a C₁₋₁₈ alkyl group, or a C₁₋₁₈ alkyl group having an ether bond,
p is an integer in a range of 1 to 30, and q is an integer of 2 or more.

In General Formulae (B-1) and (B-2) above, the C₁₋₁₈ alkyl group of R²¹ may be any of a linear alkyl group, a branched alkyl group, and a cyclic alkyl group, and specific examples thereof include a methyl group, an ethyl group, a normal-propyl group, an isopropyl group, a n-butyl group, a t-butyl group, a n-hexyl group, a cyclohexyl group, a n-octyl group, and a hexadecyl group.

The C₁₋₁₈ alkyl group of R²¹ is preferably a C₁₋₁₂ alkyl group and more preferably a C₁₋₆ alkyl group.

In General Formulae (B-1) and (B-2) above, the C₁₋₁₈ alkyl group having an ether bond of R²¹ is a group in which - CH2- in the alkyl group is replaced by an ether bond (-O-). That is, R²¹ includes a C₂₋₁₈ alkyleneoxyalkyl group, a C₃₋₁₈ polyoxyalkylenealkyl group, and a C₂₋₁₈ oxacycloalkyl group.

In General Formulae (B-1) and (B-2) above, p is an integer in a range of 1 to 30, preferably an integer in a range of 1 to 10, p is more preferably an integer in a range of 1 to 6, and p is even more preferably an integer in a range of 2 to 6.

In General Formulae (B-1) and (B-2) above, q is an integer of 2 or more. The number average of q is, for example, in a range of 2 to 100, preferably in a range of 2 to 50, more preferably in a range of 3 to 30, and even more preferably in a range of 4 to 15.

The number average of q can be read from a GPC chart.

The polymerizable monomer (2) is only required to have at least a group containing a polyester chain and preferably a compound represented by General Formula (2-1) below or a compound represented by General Formula (2-2) below. 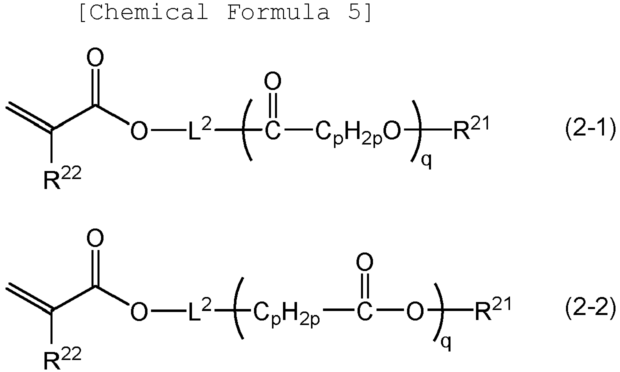 in General Formulae (2-1) and (2-2) above,
R²¹, p, and q are the same as R²¹, p, and q in General Formulae (B-1) and (B-2) above, respectively,
L² is a divalent organic group or a single bond, and
R²² is a hydrogen atom or a methyl group.

In General Formulae (2-1) and (2-2), the divalent organic group of L² is preferably a single bond, a C₁₋₅₀ alkylene group, a C₁₋₅₀ alkyleneoxy group, or a group containing a polyoxyalkylene chain.

Here, the group containing a polyoxyalkylene chain is a divalent linkage group containing a repeating part of oxyalkylene.

Examples of the C₁₋₅₀ alkylene group and the C₁₋₅₀ alkyleneoxy group of L² include the same as those of L¹.

The polymerizable monomer (2) can be produced by known methods and can be obtained by, for example, lactone modification of a polymerizable monomer having a group containing a polyoxyalkylene chain. The value of q in Formulae (B-1) and (B-2) above can be adjusted by the amount of lactone modification.

For example, the compound represented by General Formula (2-1) above can be obtained by lactone modification of a compound represented by General Formula (3-2) described later.

The polymer of the present invention is only required to be a polymer containing, as a polymeric component, the polymerizable monomer (1) and the polymerizable monomer (2), and the polymerization type thereof is not limited to a particular type.

The polymer of the present invention may be a random copolymer of the polymerizable monomer (1) and the polymerizable monomer (2) or a block copolymer of the polymerizable monomer (1) and the polymerizable monomer (2) and is preferably a block copolymer of the polymerizable monomer (1) and the polymerizable monomer (2).

When the polymer of the present invention is a block copolymer of the polymerizable monomer (1) and the polymerizable monomer (2), the number and bonding order of polymer blocks of the polymerizable monomer (1) and polymer blocks of the polymerizable monomer (2) are not limited to particular ones. The block copolymer may be a diblock copolymer, in which the polymer blocks of the polymerizable monomer (1) and the polymer blocks of the polymerizable monomer (2) are bonded together, for example.

In the polymeric component, the polymerizable monomer (1) may be a single polymerizable monomer (1) or two or more polymerizable monomers (1) having structures different from each other.

Similarly, in the polymeric component, the polymerizable monomer (2) may be a single polymerizable monomer (2) or two or more polymerizable monomers (2) having structures different from each other.

The content ratio of the polymerizable monomer (1) in the polymeric component (the polymerizable monomer (1)/a total amount of the polymeric components) is preferably in a range of 5 to 95% by mass, more preferably in a range of 5 to 75% by mass, and even more preferably in a range of 10 to 70% by mass.

The content ratio of the polymerizable monomer (1) can be adjusted by the raw material preparation ratio of the polymerizable monomer (1) when the polymer of the present invention is produced.

The content ratio of the polymerizable monomer (2) in the polymeric component (the polymerizable monomer (2)/the total amount of the polymeric components) is preferably in a range of 5 to 95% by mass, more preferably in a range of 25 to 95% by mass, and even more preferably in a range of 30 to 90% by mass.

The content ratio of the polymerizable monomer (2) can be adjusted by the raw material preparation ratio of the polymerizable monomer (2) when the polymer of the present invention is produced.

The mass ratio between the polymerizable monomer (1) and the polymerizable monomer (2) in the polymeric component is, for example, the polymerizable monomer (1):the polymerizable monomer (2) = 5 to 95:95 to 5, preferably 5 to 75:95 to 25, and more preferably 10 to 70:90 to 30.

The content ratio of the group represented by General Formula (A) above in the polymer of the present invention (the sum of the masses of the groups represented by Formula (A)/the mass of the silicone chain-containing polymer) is preferably 5 to 70% by mass and more preferably 10 to 60% by mass.

The content ratio of the group represented by General Formula (A) above can be adjusted by the raw material preparation ratio of the polymerizable monomer (1) used when the polymer of the present invention is produced.

The polymeric component is only required to contain the polymerizable monomer (1) and the polymerizable monomer (2), may substantially contain the polymerizable monomer (1) and the polymerizable monomer (2), or may contain only the polymerizable monomer (1) and the polymerizable monomer (2).

Here, "substantially contain" means that the total content ratio of the polymerizable monomer (1) and the polymerizable monomer (2) in the polymeric component is, for example, 80% by mass or more, 90% by mass or more, 95% by mass or more, or 98% by mass or more.

The polymeric component of the polymer of the present invention may contain other polymerizable monomers other than the polymerizable monomer (1) and the polymerizable monomer (2), and examples of the other polymerizable monomers include a polymerizable monomer (3) having one or more selected from a C₁₋₁₈ alkyl group, a C₆₋₁₈ aromatic group, and a group containing a polyoxyalkylene chain.

The C₁₋₁₈ alkyl group of the polymerizable monomer (3) may be any of a linear alkyl group, a branched alkyl group, and a cyclic alkyl group, and specific examples thereof include a methyl group, an ethyl group, a normal-propyl group, an isopropyl group, a n-butyl group, a t-butyl group, a n-hexyl group, a cyclohexyl group, a n-octyl group, and a hexadecyl group.

The C₁₋₁₈ alkyl group of the polymerizable monomer (3) may have one or more substituents such as a hydroxy group, a phenyl group, and a phenoxy group.

Examples of the C₁₋₁₈ alkyl group of the polymerizable monomer (3) include a C₁₋₁₈ hydroxyalkyl group, a C₇₋₁₈ phenylalkyl group, and a C₇₋₁₈ phenoxyalkyl group.

The C₁₋₁₈ alkyl group of the polymerizable monomer (3) is preferably a C₁₋₈ alkyl group.

Examples of the C₆₋₁₈ aromatic group of the polymerizable monomer (3) include a phenyl group, a naphthyl group, an anthracen-1-yl group, and a phenanthren-1-yl group.

The C₆₋₁₈ aromatic group of the polymerizable monomer (3) may further have substituents such as a hydroxy group, an alkyl group, and an alkoxy group, including a phenyl group having a C₁₋₆ alkyl group as a substituent, for example.

The group containing a polyoxyalkylene chain of the polymerizable monomer (3) is a monovalent group containing a repeating part of oxyalkylene or a divalent linkage group containing a repeating part of oxyalkylene.

Examples of the polymerizable monomer (3) having the C₁₋₁₈ alkyl group and having a (meth)acryloyl group as the polymerizable unsaturated group include C₁₋₁₈ alkyl esters of (meth)acrylic acid, such as methyl (meth)acrylate, ethyl (meth)acrylate, n-propyl (meth)acrylate, isopropyl (meth)acrylate, n-butyl (meth)acrylate, s-butyl (meth)acrylate, isobutyl (meth)acrylate, t-butyl (meth)acrylate, n-pentyl (meth)acrylate, n-hexyl (meth)acrylate, n-heptyl (meth)acrylate, n-octyl (meth)acrylate, 2-ethylhexyl (meth)acrylate, decyl (meth)acrylate, dodecyl (meth)acrylate, stearyl (meth)acrylate, and isostearyl (meth)acrylate; and C₁₋₁₈ bridged cyclic alkyl esters of (meth)acrylic acid, such as dicyclopentanyloxylethyl (meth)acrylate, isobornyloxylethyl (meth)acrylate, isobornyl (meth)acrylate, adamantyl (meth)acrylate, dimethyladamantyl (meth)acrylate, dicyclopentanyl (meth)acrylate, and dicyclopentenyl (meth)acrylate.

Examples of the polymerizable monomer (3) having the C₁₋₁₈ hydroxyalkyl group and having a (meth)acryloyl group as the polymerizable unsaturated group include 2-hydroxyethyl (meth)acrylate, 2-hydroxypropyl (meth)acrylate, 2-hydroxybutyl (meth)acrylate, 4-hydroxy (meth)acrylate, 1,4-cyclohexanedimethanol mono(meth)acrylate, and 2,3-dihydroxypropyl (meth)acrylate.

Examples of the polymerizable monomer (3) having the C₇₋₁₈ phenylalkyl group or the C₇₋₁₈ phenoxyalkyl group and having a (meth)acryloyl group as the polymerizable unsaturated group include benzyl (meth)acrylate, 2-phenoxymethyl (meth)acrylate, 2-phenoxyethyl (meth)acrylate, and 2-hydroxy-3-phenoxypropyl (meth)acrylate.

Examples of the polymerizable monomer (3) having the group containing a polyoxyalkylene chain and having a (meth)acryloyl group as the polymerizable unsaturated group include polypropylene glycol mono(meth)acrylate, polyethylene glycol mono(meth)acrylate, polytrimethylene glycol mono(meth)acrylate, polytetramethylene glycol mono(meth)acrylate, poly(ethylene glycol/propylene glycol) mono(meth)acrylate, polyethylene glycol/polypropylene glycol mono(meth)acrylate, poly(ethylene glycol/tetramethylene glycol) mono(meth)acrylate, polyethylene glycol/polytetramethylene glycol mono(meth)acrylate, poly(propylene glycol/tetramethylene glycol) mono(meth)acrylate, polypropylene glycol/polytetramethylene glycol mono(meth)acrylate, poly(propylene glycol/1,2-butylene glycol) mono(meth)acrylate, polypropylene glycol/poly(1,2-butylene glycol) mono(meth)acrylate, poly(ethylene glycol/1,2-butylene glycol) mono(meth)acrylate, polyethylene glycol/poly(1,2-butylene glycol) mono(meth)acrylate, poly(tetraethylene glycol/1,2-butylene glycol) mono(meth)acrylate, polytetraethylene glycol/poly(1,2-butylene glycol) mono(meth)acrylate, poly(1,2-butylene glycol) mono(meth)acrylate, poly(ethylene glycol/trimethylene glycol) mono(meth)acrylate, polyethylene glycol/polytrimethylene glycol mono(meth)acrylate, poly(propylene glycol/trimethylene glycol) mono(meth)acrylate, polypropylene glycol/polytrimethylene glycol mono(meth)acrylate, poly(trimethylene glycol/tetramethylene glycol) mono(meth)acrylate, polytrimethylene glycol/polytetramethylene glycol mono(meth)acrylate, poly(1,2-butylene glycol/trimethylene glycol) mono(meth)acrylate, poly(1,2-butylene glycol)/polytrimethylene glycol mono(meth)acrylate, 2-hydroxyethyl (meth)acrylate, 2-hydroxypropyl (meth)acrylate, 2-hydroxybutyl (meth)acrylate, 4-hydroxybutyl (meth)acrylate, poly(1,2-butylene glycol/tetramethylene glycol) mono(meth)acrylate, and poly(1,2-butylene glycol)/polytetramethylene glycol mono(meth)acrylate.

"Poly(ethylene glycol/propylene glycol)" above means a random copolymer of ethylene glycol and propylene glycol, and "polyethylene glycol/polypropylene glycol)" means a block copolymer of ethylene glycol and propylene glycol.

Examples of the polymerizable monomer (3) having the C₁₋₁₈ alkyl group and having a vinyl ether group as the polymerizable unsaturated group include alkyl vinyl ethers such as methyl vinyl ether, ethyl vinyl ether, n-propyl vinyl ether, isopropyl vinyl ether, n-butyl vinyl ether, isobutyl vinyl ether, tert-butyl vinyl ether, n-pentyl vinyl ether, n-hexyl vinyl ether, n-octyl vinyl ether, n-dodecyl vinyl ether, 2-ethylhexyl vinyl ether, and cyclohexyl vinyl ether; cycloalkyl vinyl ethers; 2-hydroxyethyl vinyl ether, 3-hydroxypropyl vinyl ether, 4-hydroxybutyl vinyl ether, 5-hydroxypentyl vinyl ether, 6-hydroxyhexyl vinyl ether, 1-hydroxypropyl vinyl ether, 2-hydroxypropyl vinyl ether, 1-hydroxybutyl vinyl ether, 2-hydroxybutyl vinyl ether, 3-hydroxybutyl vinyl ether, 3-hydroxy-2-methylpropyl vinyl ether, 4-hydroxy-2-methylbutyl vinyl ether, 4-hydroxycyclohexyl vinyl ether, and cyclohexane-1,4-dimethanol monovinyl ether.

Examples of the polymerizable monomer (3) having the C₁₋₁₈ alkyl group and having an allyl group as the polymerizable unsaturated group include 2-hydroxyethyl allyl ether, 4-hydroxybutyl allyl ether, and glycerol monoallyl ether.

Examples of the polymerizable monomer (3) having the C₆₋₁₈ aromatic group include styrene, α-methylstyrene, p-methylstyrene, and p-methoxystyrene.

Examples of the polymerizable monomer (3) having the C₁₋₁₈ alkyl group and having a (meth)acryloylamino group as the polymerizable unsaturated group include N,N-dimethylacrylamide, N,N-diethylacrylamide, N-isopropylacrylamide, diacetone acrylamide, and acryloylmorpholine.

Examples of the polymerizable monomer (3) having the C₁₋₁₈ alkyl group and having a maleimide group as the polymerizable unsaturated group include methylmaleimide, ethylmaleimide, propylmaleimide, butylmaleimide, hexylmaleimide, octylmaleimide, dodecylmaleimide, stearylmaleimide, and cyclohexylmaleimide.

The polymerizable monomer (3) is preferably a compound represented by General Formula (3-1) below or a compound represented by (3-2). These compounds can impart compatibility when the polymer of the present invention is used as a leveling agent. 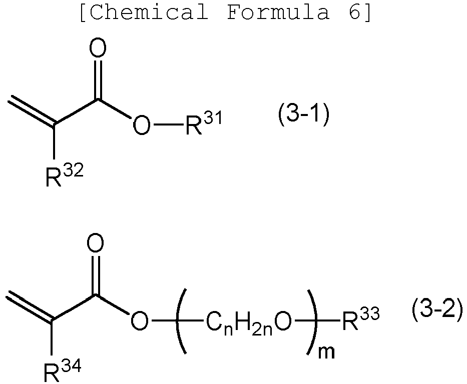 in General Formulae (3-1) and (3-2) above,
R³¹ is a C₁₋₁₈ alkyl group,
R³² is a hydrogen atom or a methyl group,
R³³ is a hydrogen atom or a C₁₋₁₈ alkyl group,
R³⁴ is a hydrogen atom or a methyl group,
n is an integer in a range of 1 to 4, and m is an integer in a range of 1 to 200.

In General Formulae (3-1) and (3-2) above, the C₁₋₁₈ alkyl group of R³¹ and R³³ is preferably a C₁₋₈ alkyl group.

In General Formula (3-2) above, m is preferably an integer in a range of 2 to 50 and more preferably an integer in a range of 3 to 20.

The polymerizable monomer (3) is preferably a compound represented by General Formula (3-3) below. 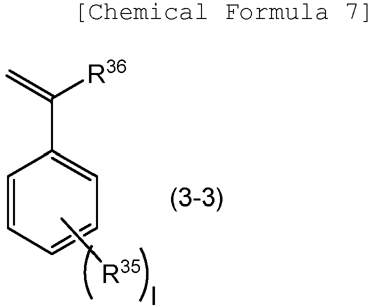 in General Formula (3-3) above,
R³⁵ are each independently a C₁₋₆ alkyl group or a C₁₋₆ alkoxy group,
R₃₆ is a hydrogen atom or a methyl group, and
1 is an integer of 0 to 5.

When the polymerizable monomer (3) is contained as the polymeric component, the content ratio of the polymerizable monomer (3) in the polymeric component (the polymerizable monomer (3)/the total amount of the polymeric components) is preferably in a range of 1 to 20% by mass and more preferably in a range of 1 to 10% by mass.

The polymerizable monomer (3) can be produced by known methods.

For the polymerizable monomer (3), commercially available products may be used. For example, examples of commercially available products of the polymerizable monomer (3-2) having the group containing a polyoxyalkylene chain and having a (meth)acryloyl group as the polymerizable unsaturated group include "NK Ester M-20G," "NK Ester M-40G," "NK Ester M-90G," "NK Ester M-230G," "NK Ester AM-90G," "NK Ester AMP-10G," "NK Ester AMP-20G," and "NK Ester AMP-60G" manufactured by Shin-Nakamura Chemical Co., Ltd.; and "Blemmer PE-90," "Blemmer PE-200," "Blemmer PE-350," "Blemmer PME-100," "Blemmer PME-200," "Blemmer PME-400," "Blemmer PME-4000," "Blemmer PP-1000," "Blemmer PP-500," "Blemmer PP-800," "Blemmer 70PEP-350B," "Blemmer 55PET-800," "Blemmer 50POEP-800B," "Blemmer 10PPB-500B," "Blemmer NKH-5050," "Blemmer AP-400," and "Blemmer AE-350" manufactured by NOF Corporation.

The polymer of the present invention does not preferably contain any fluorine atoms. Being a fluorine atom-free polymer reduces accumulativeness in the environment and can reduce the load on the environment.

The polymer of the present invention does not preferably contain any reactive functional groups.

In the present invention, the "reactive functional group" is a functional group that can react with other functional groups to form a cross-linked structure or the like, and examples thereof include an isocyanate group, an epoxy group, a carboxy group, a carboxylic halide group, and a carboxylic anhydride group.

The number average molecular weight (Mn) of the polymer of the present invention is preferably in a range of 1,000 to 500,000, more preferably in a range of 2,000 to 100,000, and even more preferably in a range of 2,000 to 20,000.

The weight average molecular weight (Mw) of the polymer of the present invention is preferably in a range of 1,000 to 500,000, more preferably in a range of 2,000 to 100,000, and even more preferably in a range of 5,000 to 40,000.

The degree of dispersion (Mw/Mn) of the polymer of the present invention is, for example, 5.0 or less, preferably 3.0 or less, more preferably 2.0 or less, and even more preferably 1.5 or less. The lower limit of the degree of dispersion, which is not limited to a particular value, is 1.0, for example.

The values of the number average molecular weight (Mn) and the weight average molecular weight (Mw) of the polymer of the present invention are measured by the method described in Examples.

### [Method for Producing Silicone Chain-Containing Polymer]

The method for producing the polymer of the present invention is not limited to a particular method, and it can be produced by known methods.

The polymer of the present invention can be produced by performing solution polymerization, bulk polymerization, emulsion polymerization, or the like on the polymeric component based on polymerization mechanisms such as radical polymerization, cationic polymerization, and anionic polymerization. For example, in the case of radical polymerization, the polymer of the present invention can be produced by charging the polymeric component into an organic solvent and adding a general-purpose radical polymerization initiator thereto.

The polymer obtained above is a random copolymer.

As the polymerization initiator, various ones can be used, and examples thereof include peroxides such as t-butylperoxy-2-ethylhexanoate, benzoyl peroxide, and diacyl peroxide; azo compounds such as azobisisobutyronitrile, dimethyl azobisisobutyrate, and phenylazotriphenylmethane; and metal chelate compounds such as Mn(acac)₃.

If necessary, a chain transfer agent such as lauryl mercaptan, 2-mercaptoethanol, ethyl thioglycolic acid, or octyl thioglycolic acid may be used, and a thiol compound having a coupling group, such as γ-mercaptopropyltrimethoxysilane, may be used as an additive for the chain transfer agent or the like.

Examples of the organic solvent include alcohols such as ethanol, isopropyl alcohol, n-butanol, iso-butanol, and tert-butanol; ketones such as acetone, methyl ethyl ketone, methyl isobutyl ketone, and methyl amyl ketone; esters such as methyl acetate, ethyl acetate, butyl acetate, methyl lactate, ethyl lactate, and butyl lactate; monocarboxylates such as 2-oxy methyl propionate, 2-oxy ethyl propionate, 2-oxy propyl propionate, 2-oxy butyl propionate, 2-methoxy methyl propionate, 2-methoxy ethyl propionate, 2-methoxy propyl propionate, and 2-methoxy butyl propionate; polar solvents such as dimethylformamide, dimethyl sulfoxide, and N-methylpyrrolidone; ethers such as methyl cellosolve, cellosolve, butyl cellosolve, butyl carbitol, and ethyl cellosolve acetate; propylene glycols and esters thereof such as propylene glycol, propylene glycol monomethyl ether, propylene glycol monomethyl ether acetate, propylene glycol monoethyl ether acetate, and propylene glycol monobutyl ether acetate; halogen-based solvents such as 1,1,1-trichloroethane and chloroform; ethers such as tetrahydrofuran and dioxane; aromatics such as benzene, toluene, and xylene; and fluorinated inert liquids such as perfluorooctane and perfluorotri-n-butylamine.

These solvents can be used alone or in combination of two or more.

The polymer of the present invention can also be produced by performing living polymerization such as living radical polymerization or living anionic polymerization on the polymeric component.

The polymer obtained above is a block copolymer.

In the living radical polymerization, a dormant species the active polymerization end of which is protected by an atom or a group of atoms reversibly generates radicals to react with a monomer, thereby causing a growth reaction to proceed, and a growth end does not lose its activity even when a first monomer is consumed and reaction with a sequentially added second monomer takes place to obtain a block polymer. Examples of such living radical polymerization include atom transfer radical polymerization (ATRP), reversible addition-fragmentation chain transfer polymerization (RAFT), nitroxide-mediated radical polymerization (NMP), and organotellurium-mediated radical polymerization (TERP). There are no particular restrictions on which of these methods should be used, but ATRP is preferred for ease of control and other reasons. ATRP performs polymerization with an organic halide, a halogenated sulfonyl compound, or the like as a polymerization initiator and with a metallic complex formed of a transition metal compound and a ligand as a catalyst.

Specific examples of the polymerization initiator that can be used for ATRP include 1-phenylethyl chloride, 1-phenylethyl bromide, chloroform, tetrachloro carbon, 2-chloro propionitrile, α,α'-dichloroxylene, α,α'-dibromoxylene, hexakis(α-bromomethyl)benzene, and C₁₋₆ alkyl esters of C₁₋₆ 2-halogenated carboxylic acids (for example, 2-chloropropionic acid, 2-bromopropionic acid, 2-chloroisobutyric acid, 2-bromoisobutyric acid, and the like) .

Specific examples of the C₁₋₆ alkyl esters of C₁₋₆ 2-halogenated carboxylic acids include methyl 2-chloropropionate, ethyl 2-chloropropionate, methyl 2-bromopropionate, and ethyl 2-bromoisobutyrate.

The transition metal compound that can be used for ATRP is represented by Mⁿ⁺Xₙ.

The transition metal Mⁿ⁺ of the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo°, Mo⁺, Mo²⁺, Mo³⁺, W²⁺, W³⁺, Rh³⁺, Rh⁴⁺, Co⁺, Co²⁺, Re²⁺, Re³⁺, Ni°, Ni⁺, Mn³⁺, Mn⁴⁺, V²⁺, V³⁺, Zn⁺, Zn²⁺, Au⁺, Au²⁺, Ag⁺, and Ag²⁺.

X of the transition metal compound represented by Mⁿ⁺Xₙ can be selected from the group consisting of halogen atoms, C₁₋₆ alkoxy groups, (SO₄)_{1/2}, (PO₄)_{1/3}, (HPO₄)_{1/2}, (H₂PO₄), triflate, hexafluorophosphate, methane sulfonate, aryl sulfonates (preferably benzenesulfonate or toluenesulfonate), SeR¹¹, CN, and R¹²COO. In the above, R¹¹ represents an aryl group or a linear or branched C₁₋₂₀ (preferably C₁₋₁₀) alkyl group, and R¹² represents a hydrogen atom or a linear or branched C₁₋₆ alkyl group (preferably a methyl group) that may be replaced by a halogen one to five times (preferably by fluorine or chlorine one to three times).

The n of the transition metal compound represented by Mⁿ⁺Xₙ represents formal charge on the metal and is an integer of 0 to 7.

Examples of a ligand compound that can form a coordinate bond with the transition metal of the transition metal compound include compounds having a ligand containing one or more nitrogen atoms, oxygen atoms, phosphorus atoms, and sulfur atoms that can coordinate with the transition metal via a σ bond; compounds having a ligand containing two or more carbon atoms that can coordinate with the transition metal via a n bond, and compounds having a ligand that can coordinate with the transition metal via a µ bond or a η bond.

The transition metal complex is not limited to a particular one, but preferred examples thereof include transition metal complexes of Groups 7, 8, 9, 10, and 11, and more preferred examples thereof include complexes of zero-valent copper, monovalent copper, divalent ruthenium, divalent iron, and divalent nickel.

Specific examples of the catalyst that can be used for ATRP include, when the central metal is copper, 2,2'-bipyridyl and derivatives thereof, 1,10-phenanthroline and derivatives thereof, and complexes with ligands such as polyamines such as tetramethylethylenediamine, pentamethyldiethylenetriamine, hexamethyl tris(2-aminoethyl)amine, tris[2-(dimethylamino)ethyl]amine, and tris(2-pyridylmethyl)amine. Examples of the divalent ruthenium complexes include dichlorotris(triphenylphosphine)ruthenium, dichlorotris(tributylphosphine)ruthenium, dichloro(cyclooctadiene)ruthenium, dichlorobenzene ruthenium, dichloro(p-cymene)ruthenium, dichloro(norbornadiene)ruthenium, cis-dichlorobis(2,2'-bipyridine)ruthenium, dichlorotris(1,10-phenanthroline)ruthenium, and carbonylchlorohydridotris(triphenylphosphine)ruthenium. Further, examples of the divalent iron complexes include bistriphenylphosphine complexes and triazacyclononane complexes.

Atom transfer radical polymerization (ATRP) is not limited to the above, and ATRP other than the above can also be performed. For example, AGET ATRP, ARGET ATRP, ICAR ATRP, and the like described in "Macromol. Rapid. Commun. 2018, 1800616" can also be employed.

A solvent is preferably used in living radical polymerization.

Examples of the solvent used in living radical polymerization include ester-based solvents such as ethyl acetate, butyl acetate, and propylene glycol monomethyl ether acetate; ether-based solvents such as diisopropyl ether, dimethoxyethane, and diethylene glycol dimethyl ether; halogen-based solvents such as dichloromethane and dichloroethane; aromatic solvents such as toluene, xylene, and anisole; ketone-based solvents such as methyl ethyl ketone, methyl isobutyl ketone, and cyclohexanone; alcohol-based solvents such as methanol, ethanol, and isopropanol (2-propanol); and aprotic polar solvents such as dimethylformamide and dimethyl sulfoxide.

The solvent may be used alone or in combination of two or more.

When the polymer of the present invention is produced by living polymerization, it can be produced by any of Methods 1 to 3 described below, for example.

Method 1: A method of performing living radical polymerization (preferably atom transfer radical polymerization) of the polymerizable monomer (1) and the polymerizable monomer (2) in the presence of a polymerization initiator, a transition metal compound, a ligand compound that can form a coordinate bond with the transition metal, and a solvent.

Method 2: A method of performing living radical polymerization (preferably atom transfer radical polymerization) of the polymerizable monomer (1) in the presence of a polymerization initiator, a transition metal compound, a ligand compound that can form a coordinate bond with the transition metal, and a solvent to obtain a polymer block of the polymerizable monomer (1) and then adding the polymerizable monomer (2) to the reaction system to further perform living radical polymerization (preferably atom transfer radical polymerization) of the polymerizable monomer (2) to the polymer block of the polymerizable monomer (1).

Method 3: A method of performing living radical polymerization (preferably atom transfer radical polymerization) of the polymerizable monomer (2) in the presence of a polymerization initiator, a transition metal compound, a ligand compound that can form a coordinate bond with the transition metal, and a solvent to obtain a polymer block of the polymerizable monomer (2) and then adding the polymerizable monomer (1) to the reaction system to further perform living radical polymerization (preferably atom transfer radical polymerization) of the polymerizable monomer (1) to the polymer block of the polymerizable monomer (2).

The polymerization temperature during the living radical polymerization is preferably in a range of room temperature to 120°C.

When the polymer of the present invention is produced by living radical polymerization, there may be residual metals caused by the transition metal compound used in the polymerization in the resulting polymer. The residual metals in the resulting polymer may be removed using activated alumina or the like after the end of the polymerization.

### [Coating Composition]

The polymer of the present invention can be suitably used as a leveling agent for coating compositions, and the coating composition of the present invention contains the polymer of the present invention. The polymer of the present invention can be made into a fluorine atom-free leveling agent that does not contain any fluorine atoms, thus making it a leveling agent with low accumulativeness in the environment and a low load on the environment.

The content of the polymer of the present invention contained in the coating composition of the present invention, which varies depending on the type of a base resin, the method of application, a desired film thickness, or the like, is preferably 0.001 to 10 parts by mass, more preferably 0.01 to 5 parts by mass, and even more preferably 0.05 to 1 part by mass with respect to 100 parts by mass of the solid content of the coating composition. When the content of the polymer of the present invention is within the range, the surface tension can be sufficiently lowered, desired leveling properties can be obtained, and the occurrence of problems such as foaming during application can be reduced.

The use of the coating composition of the present invention is not limited to a particular use, and it can be used for any uses where leveling properties are required. The coating composition of the present invention can be used as, for example, various paint compositions or photosensitive resin compositions.

When the coating composition of the present invention is used as a paint composition, examples of the paint composition include paints containing natural resins, such as petroleum resin paints, shellac paints, rosin-based paints, cellulose-based paints, rubber-based paints, lacquer paints, cashew resin paints, and oil-based vehicle paints; and paints containing synthetic paints, such as phenolic resin paints, alkyd resin paints, unsaturated polyester resin paints, amino resin paints, epoxy resin paints, vinyl resin paints, acrylic resin paints, polyurethane resin paints, silicone resin paints, and fluororesin paints.

By adding the polymer of the present invention to the paint composition, smoothness can be imparted to the resulting coating film.

If necessary, various additives can be added to the paint composition as appropriate, such as colorants such as pigments, dyes, and carbons; inorganic powders such as silica, titanium oxide, zinc oxide, aluminum oxide, zirconium oxide, calcium oxide, and calcium carbonate; organic fine powders such as higher fatty acids, polyacrylic resins, and polyethylenes; lightfastness improvers, weather resistance improvers, heat resistance improvers, antioxidants, thickeners, and anti-settling agents.

As to the method of coating for the coating composition of the present invention, any method can be used so long as it is a known and commonly used method of coating, and examples thereof include methods such as slit coaters, slit and spin coaters, spin coaters, roll coaters, electrostatic coating, bar coaters, gravure coaters, die coaters, knife coaters, inkjetting, dipping application, spray application, shower coating, screen printing, gravure printing, offset printing, and reverse coating.

The photosensitive resin compositions change their physical properties of the resin, such as solubility, viscosity, transparency, refractive index, conductivity, and ion permeability, upon irradiation with light such as visible light or ultraviolet light.

Among the photosensitive resin compositions, resist compositions (photoresist compositions, color resist compositions for color filters, and the like) require a high degree of leveling properties. The resist compositions are usually applied by spin coating so as to give a thickness of about 1 to 2 um on silicon wafers or on glass substrates on which various metals are deposited. In this process, if the application film thickness fluctuates or application unevenness occurs, there arises problems in that the linearity and/or reproducibility of patterns deteriorate, and a resist pattern having desired accuracy cannot be obtained. In addition to these problems, there are various leveling-related problems such as drop marks, the entire unevenness, and the bead phenomenon, in which edges are thicker than the central part.

The coating composition of the present invention, owing to the polymer of the present invention exhibiting a high degree of leveling properties, can form a uniform coating film (cured product) and can thus solve the above problems when it is used as a resist composition.

When the coating composition of the present invention is used as a photoresist composition, the photoresist composition contains an alkali-soluble resin, a radiosensitive substance (a photosensitive substance), a solvent, and the like in addition to the polymer of the present invention.

The alkali-soluble resin contained in the photoresist composition is a resin soluble in alkaline solutions, which are developers used during resist patterning.

Examples of the alkali-soluble resin include novolac resins obtained by condensing an aromatic hydroxy compound derivative such as phenol, cresol, xylenol, resorcinol, phloroglucinol, or hydroquinone and an aldehyde compound such as formaldehyde, acetaldehyde, or benzaldehyde; polymers and copolymers of vinylphenol compound derivatives such as o-vinylphenol, m-vinylphenol, p-vinylphenol, and α-methylvinylphenol; (meth)acrylic acid-based polymers and copolymers such as acrylic acid, methacrylic acid, and hydroxyethyl (meth)acrylate; polyvinyl alcohol; modified resins in which radiosensitive groups such as a quinonediazide group, a naphthoquinone azide group, an aromatic azide group, and an aromatic cinnamoyl group are introduced via part of the hydroxy groups of these various resins; and urethane resins containing acidic groups such as carboxylic acid and sulfonic acid in their molecules.

These alkali-soluble resins may be used alone or in combination of two or more.

The radiosensitive substance contained in the photoresist composition is a substance changing the solubility of the alkali-soluble resin in the developer by being irradiated with energy rays such as ultraviolet rays, far-ultraviolet rays, excimer laser light, X-rays, electron beams, ion beams, molecular beams, and gamma rays.

Examples of the radiosensitive substance include quinonediazide-based compounds, diazo-based compounds, azide-based compounds, onium salt compounds, halogenated organic compounds, mixtures of halogenated organic compounds and organometallic compounds, organic acid ester compounds, organic acid amide compounds, organic acid imide compounds, and poly(olefin sulfone) compounds.

Examples of the quinonediazide-based compounds include 1,2-benzoquinone azide-4-sulfonate, 1,2-naphthoquinone diazide-4-sulfonate, 1,2-naphthoquinone diazide-5-sulfonate, 2,1-naphthoquinone diazide-4-sulfonate, 2,1-naphthoquinone diazide-5-sulfonate, and sulfonic acid chloride of quinonediazide derivatives such as 1,2-benzoquinone azide-4-sulfonic acid chloride, 1,2-naphtoquinone diazide-4-sulfonic acid chloride, 1,2-naphtoquinone diazide-5-sulfonic acid chloride, 2,1-naphtoquinone diazide-4-sulfonic acid chloride, and 2,1-naphtoquinone diazide-5-sulfonic acid chloride.

Examples of the diazo-based compounds include salts of a condensate of p-diazodiphenylamine and formaldehyde or acetaldehyde, diazo resin inorganic salts as reaction products of hexafluorophosphate, tetrafluoroborate, perchlorate, or periodate and the above condensate, and diazo resin organic salts of reaction products of the above condensate and sulfonic acids, such as those described in United States Patent No. 3,300,309.

Examples of the azide-based compounds include azidochalconic acid, diazidobenzalmethylcyclohexanones, azidocinnamylidene acetophenones, aromatic azide compounds, and aromatic diazide compounds.

Examples of the halogenated organic compounds include halogen-containing oxadiazole-based compounds, halogen-containing triazine-based compounds, halogen-containing acetophenone-based compounds, halogen-containing benzophenone-based compounds, halogen-containing sulfoxide-based compounds, halogen-containing sulfone-based compounds, halogen-containing thiazole-based compounds, halogen-containing oxazole-based compounds, halogen-containing triazole-based compounds, halogen-containing 2-pyrone-based compounds, halogen-containing aliphatic hydrocarbon-based compounds, halogen-containing aromatic hydrocarbon-based compounds, halogen-containing heterocyclic compounds, and sulfenyl halide-based compounds.

In addition to the above, examples of the halogenated organic compounds also include compounds used as halogen-based flame retardants such as tris(2,3-dibromopropyl)phosphate, tris(2,3-dibromo-3-chloropropyl)phosphate, chlorotetrabromomethane, hexachlorobenzene, hexabromobenzene, hexabromocyclododecane, hexabromobiphenyl, tribromophenylallyl ether, tetrachlorobisphenol A, tetrabromobisphenol A, bis(bromoethyl ether)tetrabromobisphenol A, bis(chloroethyl ether)tetrachlorobisphenol A, tris(2,3-dibromopropyl)isocyanurate, 2,2-bis(4-hydroxy-3,5-dibromophenyl)propane, and 2,2-bis(4-hydroxyethoxy-3,5-dibromophenyl)propane and compounds used as organochlorinated agrochemicals such as dichlorophenyl trichloroethane.

Examples of the organic acid esters include carboxylates and sulfonates. Examples of the organic acid amides include carboxylic acid amides and sulfonic acid amides. Further, examples of the organic acid imides include carboxylic acid imides and sulfonic acid imides.

The radiosensitive substance may be used alone or in combination of two or more.

In the photoresist composition, the content of the radiosensitive substance is preferably in a range of 10 to 200 parts by mass and more preferably in a range of 50 to 150 parts by mass with respect to 100 parts by mass of the alkali-soluble resin.

Examples of the solvent for the photoresist composition include ketones such as acetone, methyl ethyl ketone, cyclohexanone, cyclopentanone, cycloheptanone, 2-heptanone, methyl isobutyl ketone, and butyrolactone; alcohols such as methanol, ethanol, n-propyl alcohol, isopropyl alcohol, n-butyl alcohol, iso-butyl alcohol, tert-butyl alcohol, pentanol, heptanol, octanol, nonanol, and decanol; ethers such as ethylene glycol dimethyl ether, ethylene glycol diethyl ether, and dioxane; alcohol ethers such as ethylene glycol monomethyl ether, ethylene glycol monoethyl ether, ethylene glycol monopropyl ether, propylene glycol monomethyl ether, propylene glycol monoethyl ether, and propylene glycol monopropyl ether; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, and butyl lactate; monocarboxylic acid esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, and butyl 2-methoxypropionate; cellosolve esters such as cellosolve acetate, methyl cellosolve acetate, ethyl cellosolve acetate, propyl cellosolve acetate, and butyl cellosolve acetate; propylene glycols such as propylene glycol, propylene glycol monomethyl ether, propylene glycol monomethyl ether acetate, propylene glycol monoethyl ether acetate, and propylene glycol monobutyl ether acetate; diethylene glycols such as diethylene glycol monomethyl ether, diethylene glycol monoethyl ether, diethylene glycol dimethyl ether, diethylene glycol diethyl ether, and diethylene glycol methylethyl ether; halogenated hydrocarbons such as trichloroethylene, CFC solvents, HCFC, and HFC; fully fluorinated solvents such as perfluorooctane; aromatics such as toluene and xylene; and polar solvents such as dimethylacetamide, dimethylformamide, N-methylacetamide, and N-methylpyrrolidone.

These solvents may be used alone or in combination of two or more.

When the coating composition of the present invention is used as a color resist composition, the color resist composition contains an alkali-soluble resin, a polymerizable compound, a colorant, and the like in addition to the polymer of the present invention.

For the alkali-soluble resin contained in the color resist, the same as the alkali-soluble resin contained in the photoresist composition described above can be used.

The polymerizable compound contained in the color resist composition is a compound having a photopolymerizable functional group capable of polymerization or a crosslinking reaction by irradiation with active energy rays such as ultraviolet rays.

Examples of the polymerizable compound include unsaturated carboxylic acids such as (meth)acrylic acid, esters of a monohydroxy compound and an unsaturated carboxylic acid, esters of an aliphatic polyhydroxy compound and an unsaturated carboxylic acid, esters of an aromatic polyhydroxy compound and an unsaturated carboxylic acid, esters obtained by an esterification reaction of an unsaturated carboxylic acid, a polycarboxylic acid, and a polyhydroxy compound such as the aliphatic polyhydroxy compound or the aromatic polyhydroxy compound described above, polymerizable compounds having a urethane skeleton by reaction of a polyisocyanate compound and a (meth)acryloyl group-containing hydroxy compound, and polymerizable compounds having acid groups.

The polymerizable compound may be used alone or in combination of two or more.

Examples of the esters of an aliphatic polyhydroxy compound and an unsaturated carboxylic acid include (meth)acrylates such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, and glycerol (meth)acrylate.

Examples thereof also include itaconates, in which the part of (meth)acrylic acid of these acrylates is replaced by itaconic acid, crotonates, in which the part is replaced by crotonic acid, and maleates, in which the part is replaced by maleic acid.

Examples of the esters of an aromatic polyhydroxy compound and an unsaturated carboxylic acid include hydroquinone di(meth)acrylate, resorcinol di(meth)acrylate, and pyrogallol tri(meth)acrylate.

The esters obtained by an esterification reaction of an unsaturated carboxylic acid, a polycarboxylic acid, and a polyhydroxy compound may be a single product or a mixture. Examples of such esters include esters obtained from (meth)acrylic acid, phthalic acid, and ethylene glycol, esters obtained from (meth)acrylic acid, maleic acid, and diethylene glycol, esters obtained from (meth)acrylic acid, terephthalic acid, and pentaerythritol, and esters obtained from (meth)acrylic acid, adipic acid, butanediol, and glycerin.

Examples of the polymerizable compounds having a urethane skeleton by reaction of a polyisocyanate compound and a (meth)acryloyl group-containing hydroxy compound include aliphatic diisocyanates such as hexamethylene diisocyanate and trimethylhexamethylene diisocyanate; alicyclic diisocyanates such as cyclohexane diisocyanate and isophorone diisocyanate; and reaction products of an aromatic diisocyanate such as tolylene diisocyanate or diphenylmethane diisocyanate and a hydroxy compound having a (meth)acryloyl group, such as 2-hydroxyethyl (meth)acrylate or 3-hydroxy-[1,1,1-tri(meth)acryloyloxymethyl]propane.

The polymerizable compounds having acid groups are, for example, esters of an aliphatic polyhydroxy compound and an unsaturated carboxylic acid and preferably multifunctional polymerizable compounds caused to have acid groups by reacting a non-aromatic carboxylic anhydride with unreacted hydroxy groups of an aliphatic polyhydroxy compound. As the aliphatic polyhydroxy compound for use in the preparation of the multifunctional polymerizable compounds, pentaerythritol or dipentaerythritol is preferred.

The acid value of the multifunctional polymerizable compounds is preferably in a range of 0.1 to 40 and more preferably in a range of 5 to 30 because of good developability, curability, and the like. When two or more multifunctional polymerizable compounds having acid groups are used in combination, and when a multifunctional polymerizable compound having acid groups and a multifunctional polymerizable compound having no acid groups are used in combination, the acid value of the mixture of the polymerizable compounds is preferably within the above range.

Specific examples of the polymerizable compounds having acid groups include a mixture mainly containing dipentaerythritol hexaacrylate, dipentaerythritol pentaacrylate, and succinate of dipentaerythritol pentaacrylate, and the mixture is commercially available as Aronix TO-1382 (manufactured by Toagosei Co., Ltd.).

Examples of polymerizable compounds other than the above include (meth)acrylamides such as ethylene bis(meth)acrylamide; allyl esters such as diallyl phthalate; and compounds having vinyl groups such as divinyl phthalate.

In the color resist composition, the content of the polymerizable compound is preferably in a range of 5 to 80% by mass, more preferably in a range of 10 to 70% by mass, and even more preferably in a range of 20 to 50% by mass of the total solid content of the color resist composition.

The colorant of the color resist composition is not limited to a particular colorant so long as it can perform coloring, and it may be a pigment or a dye, for example.

As the pigment, both organic pigments and inorganic pigments can be used. Examples of the organic pigments include pigments of various hues, such as red pigments, green pigments, blue pigments, yellow pigments, violet pigments, orange pigments, and brown pigments. Examples of the chemical structure of the organic pigments include azo-based, phthalocyanine-based, quinacridone-based, benzimidazolone-based, isoindolinone-based, dioxazine-based, indanthrene-based, and perylene-based ones. Examples of the inorganic pigments include barium sulfate, lead sulfate, titanium oxide, yellow lead, red oxide, and chromium oxide.

Note that "C.I." below means Color Index.

Examples of the red pigments include C.I. Pigment Red 1, 2, 3, 4, 5, 6, 7, 8, 9, 12, 14, 15, 16, 17, 21, 22, 23, 31, 32, 37, 38, 41, 47, 48, 48: 1, 48: 2, 48: 3, 48: 4, 49, 49: 1, 49: 2, 50: 1, 52: 1, 52: 2, 53, 53: 1, 53: 2, 53: 3, 57, 57: 1, 57: 2, 58: 4, 60, 63, 63: 1, 63: 2, 64, 64: 1, 68, 69, 81, 81: 1, 81: 2, 81: 3, 81: 4, 83, 88, 90: 1, 101, 101: 1, 104, 108, 108: 1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276. Among these, preferred is C.I. Pigment Red 48: 1, 122, 168, 177, 202, 206, 207, 209, 224, 242, or 254, and more preferred is C.I. Pigment Red 177, 209, 224, or 254.

Examples of the green pigments include C.I. Pigment Green 1, 2, 4, 7, 8, 10, 13, 14, 15, 17, 18, 19, 26, 36, 45, 48, 50, 51, 54, 55, and 58. Among these, C.I. Pigment Green 7, 36, or 58 is preferred.

Examples of the blue pigments include C.I. Pigment Blue 1, 1: 2, 9, 14, 15, 15: 1, 15: 2, 15: 3, 15: 4, 15: 6, 16, 17, 19, 25, 27, 28, 29, 33, 35, 36, 56, 56: 1, 60, 61, 61: 1, 62, 63, 66, 67, 68, 71, 72, 73, 74, 75, 76, 78, and 79. Among these, preferred is C.I. Pigment Blue 15, 15: 1, 15: 2, 15: 3, 15: 4, or 15: 6, and C.I. Pigment Blue 15: 6 is more preferred.

Examples of the yellow pigments include C.I. Pigment Yellow 1, 1: 1, 2, 3, 4, 5, 6, 9, 10, 12, 13, 14, 16, 17, 24, 31, 32, 34, 35, 35: 1, 36, 36: 1, 37, 37: 1, 40, 41, 42, 43, 48, 53, 55, 61, 62, 62: 1, 63, 65, 73, 74, 75, 81, 83, 87, 93, 94, 95, 97, 100, 101, 104, 105, 108, 109, 110, 111, 116, 117, 119, 120, 126, 127, 127: 1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191: 1, 192, 193, 194, 195, 196, 197, 198, 199, 200, 202, 203, 204, 205, 206, 207, and 208. Among these, preferred is C.I. Pigment Yellow 83, 117, 129, 138, 139, 150, 154, 155, 180, or 185, and more preferred is C.I. Pigment Yellow 83, 138, 139, 150, or 180.

Examples of the violet pigments include C.I. Pigment Violet 1, 1: 1, 2, 2: 2, 3, 3: 1, 3: 3, 5, 5: 1, 14, 15, 16, 19, 23, 25, 27, 29, 31, 32, 37, 39, 42, 44, 47, 49, and 50. Among these, C.I. Pigment Violet 19 or 23 is preferred, and C.I. Pigment Violet 23 is more preferred.

Examples of the orange pigments include C.I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79. Among these, C.I. Pigment Orange 38 or 71 is preferred.

Pixels of the three primary colors of color filters for use in liquid crystal display devices and organic electroluminescence (EL) display devices are red (R), green (G), and blue (B), and thus the red pigments, the green pigments, and the blue pigments may be used as a main component, and the organic pigments of colors such as yellow, violet, and orange may be used as hue adjustment for the purpose of improving color reproducibility.

The average particle size of the organic pigments is preferably 1 um or less, more preferably 0.5 um or less, and even more preferably 0.3 um or less in order to increase the luminance of color liquid crystal display devices and organic EL display devices. To achieve these average particle sizes, it is preferable to use the organic pigments subjected to dispersion processing.

The average primary particle size of the organic pigments is preferably 100 nm or less, more preferably 50 nm or less, even more preferably 40 nm or less, and particularly preferably in a range of 10 to 30 nm.

The average particle size of the organic pigments is one measured with a dynamic light scattering particle size distribution meter, and it can be measured with, for example, Nanotrac particle size distribution analyzer "UPA-EX150," "UPA-EX250," or the like manufactured by Nikkiso Co., Ltd.

The colorant when the color resist composition is used to form a black matrix (BM) is not limited to a particular colorant so long as it is black, and examples thereof include carbon black, lamp black, acetylene black, bone black, thermal black, channel black, furnace black, graphite, iron black, and titanium black. Among these, carbon black and titanium black are preferred from the viewpoint of light-shielding rate and image characteristics.

In addition, two or more organic pigments may be mixed together, and a combination to make black by color mixing may be employed.

Examples of commercially available products of the carbon black include MA7, MA8, MA11, MA100, MA100R, MA220, MA230, MA600, #5, #10, #20, #25, #30, #32, #33, #40, #44, #45, #47, #50, #52, # 55, #650, #750, #850, #950, #960, #970, #980, #990, #1000, #2200, #2300, #2350, #2400, #2600, #3050, #3150, #3250, #3600, #3750, #3950, #4000, #4010, OIL7B, OIL9B, OIL11B, OIL30B, and OIL31B manufactured by Mitsubishi Chemical Corporation; Printex3, Printex3OP, Printex30, Printex30OP, Printex40, Printex45, Printex55, Printex60, Printex75, Printex80, Printex85, Printex90, Printex A, Printex L, Printex G, Printex P, Printex U, Printex V, Printex G, SpecialBlack550, SpecialBlack 350, SpecialBlack250, SpecialBlack100, SpecialBlack6, SpecialBlack5, SpecialBlack4, Color Black FW1, Color Black FW2, Color Black FW 2V, Color Black FW18, Color Black FW18, Color Black FW200, Color Black S160, and Color Black S170 manufactured by Evonik Degussa Japan Co., Ltd.; Monarch120, Monarch280, Monarch460, Monarch800, Monarch880, Monarch900, Monarch1000, Monarch1100, Monarch1300, Monarch1400, Monarch4630, REGAL99, REGAL99R, REGAL415, REGAL415R, REGAL250, REGAL250R, REGAL330, REGAL400R, REGAL55R0, REGAL660R, BLACK PEARLS480, PEARLS130, VULCAN XC72R, and ELFTEX-8 manufactured by Cabot Japan K.K.; and RAVEN11, RAVEN14, RAVEN15, RAVEN16, RAVEN22, RAVEN30, RAVEN35, RAVEN40, RAVEN410, RAVEN420, RAVEN450, RAVEN500, RAVEN780, RAVEN850, RAVEN890H, RAVEN1000, RAVEN1020, RAVEN1040, RAVEN1060U, RAVEN1080U, RAVEN1170, RAVEN1190U, RAVEN1250, RAVEN1500, RAVEN2000, RAVEN2500U, RAVEN3500, RAVEN 5000, RAVEN5250, RAVEN5750, and RAVEN7000 manufactured by Columbian Carbon Co.

Among the above carbon blacks, carbon blacks coated with resin are preferred as they have high optical density and high surface resistivity required for the black matrix of color filters.

Examples of commercially available products of the titanium black include Titanium Black 10S, 12S, 13R, 13M, and 13M-C manufactured by Mitsubishi Materials Corporation.

As the colorant when used to form the black matrix (BM), two or more organic pigments may be mixed together to form black by color mixing, and examples thereof include black pigments obtained by mixing together pigments of three colors: red, green, and blue.

Examples of coloring materials that can be used in mixture in order to prepare the black pigments include Victoria Pure Blue (C.I. 42595), Auramine O (C.I. 41000), Cathilon Brilliant Flavin (Basic 13), Rhodamine 6GCP (C.I. 45160), Rhodamine B (C.I. 45170), Safranin OK70: 100 (C.I. 50240), Erioglaucine X (C.I. 42080), No. 120/Lionol Yellow (C.I. 21090), Lionol Yellow GRO (C.I. 21090), Symuler Fast Yellow 8GF (C.I. 21105), Benzidine Yellow 4T-564D (C.I. 21095), Symuler Fast Red 4015 (C.I. 12355), Lionol Red 7B4401 (C.I. 15850), Fastogen Blue TGR-L (C.I. 74160), Lionol Blue SM (C.I. 26150 ), Lionol Blue ES (C.I. Pigment Blue 15: 6), Lionogen Red GD (C.I. Pigment Red 168), and Lionol Green 2YS (C.I. Pigment Green 36).

Examples of other coloring materials that can be used in mixture in order to prepare the black pigments include C.I. Pigment Yellow 20, 24, 86, 93, 109, 110, 117, 125, 137, 138, 147, 148, 153, 154, and 166; C.I. Pigment Orange 36, 43, 51, 55, 59, and 61; C.I. Pigment Red 9, 97, 122, 123, 149, 168, 177, 180, 192, 215, 216, 217, 220, 223, 224, 226, 227, 228, and 240; C.I. Pigment Violet 19, 23, 29, 30, 37, 40, and 50; C.I. Pigment Blue 15, 15: 1, 15: 4, 22, 60, and 64; C.I. Pigment Green 7; and C.I. Pigment Brown 23, 25, and 26.

When carbon black is used as the black pigments, the average primary particle size of carbon black is preferably in a range of 0.01 to 0.08 um and, due to good developability, more preferably in a range of 0.02 to 0.05 µm.

Carbon black differs from organic pigments and the like in particle shape, is present in a state called a structure, in which primary particles are fused together, and may form fine pores on the particle surface by posttreatment. Thus, to represent the particle shape of carbon black, it is generally preferable to measure a DBP absorption amount (JIS K6221) and a specific surface area by the BET method (JIS K6217) as indicators of the structure and the number of pores in addition to the average particle size of primary particles, which is determined by the same method as that for the organic pigments described above.

The dibutyl phthalate (hereinafter, abbreviated as "DBP") absorption amount of carbon black is preferably in a range of 40 to 100 cm³/100 g and, due to good dispersibility and developability, more preferably in a range of 50 to 80 cm³/100 g. The specific surface area of carbon black by the BET method is preferably in a range of 50 to 120 m²/g and, due to good dispersion stability, more preferably in a range of 60 to 95 m²/g.

Examples of the dye as the colorant in the color resist composition include azo-based dyes, anthraquinone-based dyes, phthalocyanine-based dyes, quinoneimine-based dyes, quinoline-based dyes, nitro-based dyes, carbonyl-based dyes, and methine-based dyes.

Examples of the azo-based dyes include C.I. Acid Yellow 11, C.I. Acid Orange 7, C.I. Acid Red 37, C.I. Acid Red 180, C.I. Acid Blue 29, C.I. Direct Red 28, C.I. Direct Red 83, C.I. Direct Yellow 12, C.I. Direct Orange 26, C.I. Direct Green 28, C.I. Direct Green 59, C.I. Reactive Yellow 2, C.I. Reactive Red 17, C.I. Reactive Red 120, C.I. Reactive Black 5, C.I. Disperse Orange 5, C.I. Disperse Red 58, C.I. Disperse Blue 165, C.I. Basic Blue 41, C.I. Basic Red 18, C.I. Mordant Red 7, C.I. Mordant Yellow 5, and C.I. Mordant Black 7.

Examples of the anthraquinone-based dyes include C.I. Vat Blue 4, C.I. Acid Blue 40, C.I. Acid Green 25, C.I. Reactive Blue 19, C.I. Reactive Blue 49, C.I. Disperse Red 60, C.I. Disperse Blue 56, and C.I. Disperse Blue 60.

Examples of the phthalocyanine-based dyes include C.I. Pad Blue 5, examples of the quinoneimine-based dyes include C.I. Basic Blue 3 and C.I. Basic Blue 9, examples of the quinoline-based dyes include C.I. Solvent Yellow 33, C.I. Acid Yellow 3, and C.I. Disperse Yellow 64, and examples of the nitro-based dyes include C.I. Acid Yellow 1, C.I. Acid Orange 3, and C.I. Disperse Yellow 42.

For the colorant of the color resist composition, the pigment is preferably used in view of the obtained coating film having excellent lightfastness, weather resistance, and robustness, but the dye may be used in combination with the pigment as needed in order to adjust hues.

In the color resist composition, the content of the colorant is preferably 1% by mass, more preferably in a range of 5 to 80% by mass, and even more preferably in a range of 5 to 70% by mass of the total solid content of the color resist composition.

When the color resist composition is used to form the red (R), green (G), and blue (B) pixels of color filters, the content of the colorant in the color resist composition is preferably in a range of 5 to 60% by mass and more preferably in a range of 10 to 50% by mass of the total solid content of the color resist composition.

When the color resist composition is used to form the black matrix of color filters, the content of the colorant in the color resist composition is preferably in a range of 20 to 80% by mass and more preferably in a range of 30 to 70% by mass of the total solid content of the color resist composition.

In the color resist composition, when the colorant is the pigment, it is preferable to use it as a pigment dispersion liquid prepared by dispersing the pigment in an organic solvent using a dispersant.

Examples of the dispersant include surfactants; intermediates and derivatives of pigments; intermediates and derivatives of dyes; and resin-type dispersants such as polyamide-based resins, polyurethane-based resins, polyester-based resins, and acrylic resins. Among these, preferred are graft copolymers having nitrogen atoms, acrylic block copolymers having nitrogen atoms, and urethane resin dispersants, and the like. These dispersants have nitrogen atoms, and thus the nitrogen atoms have an affinity for the pigment surface, and the parts other than the nitrogen atoms increase their affinity for the medium, thereby improving dispersion stability.

These dispersants may be used alone or in combination of two or more.

Examples of commercially available products of the dispersant include the "Efka" series ("Efka 46" and the like) manufactured by BASF; the "Disperbyk" series and the "BYK" series ("BYK-160," "BYK-161," "BYK-2001," and the like) manufactured by BYK-Chemie Japan KK; the "Solsperse" series manufactured by Lubrizol Japan Limited; the "KP" series manufactured by Shin-Etsu Chemical Co., Ltd.; the "Polyflow" series manufactured by Kyoeisha Chemical Co., Ltd.; the "Disparlon" series by Kusumoto Chemicals, Ltd.; and the "Ajisper" series ("Ajisper PB-814" and the like) manufactured by Ajinomoto Fine-Techno Co., Inc.

Examples of the organic solvent used in the preparation of the pigment dispersion liquid include acetate-based solvents such as propylene glycol monomethyl ether acetate and propylene glycol monoethyl ether acetate; propionate-based solvents such as ethoxypropionate; aromatic solvents such as toluene, xylene, and methoxybenzene; ether-based solvents such as butyl cellosolve, propylene glycol monomethyl ether, diethylene glycol ethyl ether, and diethylene glycol dimethyl ether; ketone-based solvents such as methyl ethyl ketone, methyl isobutyl ketone, and cyclohexanone; aliphatic hydrocarbon-based solvents such as hexane; nitrogen compound-based solvents such as N,N-dimethylformamide, γ-butyrolactam, and N-methyl-2-pyrrolidone; lactone-based solvents such as γ-butyrolactone; and carbamates.

These solvents may be used alone or in combination of two or more.

Examples of the method for preparing the pigment dispersion liquid include a method including a kneading and dispersion step and a fine dispersion step for the colorant and a method including only the fine dispersion step. In the kneading and dispersion step, the colorant, part of the alkali-soluble resin, and, as needed, the dispersant are mixed and kneaded together. The colorant can be dispersed by dispersing it while applying strong shear force using a kneader.

Examples of a machine for use in kneading include two-roll mills, three-roll mills, ball mills, tron mills, disper, kneaders, co-kneaders, homogenizers, blenders, and single- or twin-screw extruders.

It is preferable to make the particle size of the colorant finer by salt milling or the like before performing the kneading.

In the fine dispersion step, the composition containing the colorant obtained in the kneading and dispersion step with a solvent added or a mixture of the colorant, the alkali-soluble resin, a solvent and, as needed, the dispersant is mixed and dispersed together with a fine particle dispersion medium of glass, zirconia or ceramic using a dispersing machine, whereby the particles of the colorant can be dispersed to a microscopic state close to primary particles.

From the viewpoint of improving the transmittance, contrast, and the like of color filters, the average particle size of the primary particles of the colorant is preferably 10 to 100 nm and more preferably 10 to 60 nm. The average particle size of the colorant is one measured with a dynamic light scattering particle size distribution meter, and it can be measured with, for example, Nanotrac particle size distribution analyzer "UPA-EX150," "UPA-EX250," or the like manufactured by Nikkiso Co., Ltd.

The above exemplifies the paint composition, the photoresist composition, and the color resist composition as the coating composition, but they are not limiting.

Specific examples of the use of the coating composition of the present invention include anti-glare (AG) hard coating materials, antireflective (LR) coating materials, low-refractive index layer coating materials, high-refractive index layer coating materials, clear hard coating materials, and polymerizable liquid crystal coating materials used as coating materials for screens of various displays such as liquid crystal displays (hereinafter, referred to as "LCDs"), plasma displays (hereinafter, referred to as "PDPs"), organic EL displays (hereinafter, abbreviated as "OLEDs"), and quantum dot displays (hereinafter abbreviated as "QDDs"); color resists, inkjet inks, and printing inks and paints for forming pixels of RGB and the like of color filters (hereinafter abbreviated as "CFs") of LCDs and the like; black resists, inkjet inks, and printing inks and paints for forming black matrices, black column spacers, and black photo spacers of CFs of LCDs and the like; transparent protective paints protecting CF surfaces used for CFs of LCDs and the like; resin compositions for liquid crystal materials, column spacers, and photo spacers of LCDs; resin compositions for pixel partition walls, positive photoresists for electrode formation, protective films, insulating films, plastic housings, paints for plastic housings, and bezel (picture frame) inks of LCDs, PDPs, OLEDs, QDDs, and the like; prism sheets and light diffusion films used as backlight components of LCDs; paints for organic insulating films of liquid crystal TFT arrays of LCDs; internal polarizer surface protective coating materials of LCDs; phosphors of PDPs; organic EL materials and sealants (protective films and gas barriers) of OLEDs; quantum dot inks, sealants, and protective films of QDDs; high-refractive index lenses, low-refractive index sealing, LED pixels of micro (mini) LED displays; positive photoresists, chemically amplified photoresists, antireflective films, multilayer materials (SOC and SOG), underlayer films, buffer coatings, chemicals such as developers, rinsing liquids, pattern collapse preventing agents, polymer residue removers, and cleaning agents, and nanoimprint release agents for use in semiconductor manufacture; resin compositions (resin compositions such as epoxy resins, phenolic resins, polyphenylene ether resins, liquid crystal polymers, polyimide resins, bismaleimide resins, bisallylnadimide resins, and benzoxazine resins), copper clad laminates, copper foils with resin, build-up films, passivation films, interlayer insulation films, flexible copper clad laminates, and dry film resists for semiconductor downstream processes and printed wiring boards; color resists for image sensors; liquid repellents for solder fluxes; dispersants, paints, and green sheets for laminated ceramic capacitors; positive electrode materials, negative electrode materials, separators, and electrolytes for lithium-ion batteries; exterior paints, rubbers, elastomers, glasses, vapor deposition material anchor coatings, headlamp lenses, solid lubricant paints, heat dissipating substrates, interior paints, and repair paints for cars; wallpapers, flooring materials, kitchen components, and bathroom and toilet components for housing equipment; inkjet inks, offset printing inks, gravure printing inks, and screen printing inks for printed matter, photoresists for printing plate manufacturing processes, photosensitive materials for planographic printing plates (PS plates), package adhesives, and ballpoint pen inks; and primers for easy adhesion of plastic films and the like; water repellents for textiles; non-diffusion agents for greases; cleaning liquids for cleaning surfaces of various products and components; hard coating materials for optical recording media such as CDs, DVDs, and Blu-ray discs; paints and hard coating materials for housings and screens for smartphones and cellphones; hard coating material for transfer films for insert molding (IMD and IMF); mold release films; paints and coating materials for various plastic molded products such as housings of home appliances; printing ink and paints for various building materials such as decorative panels; coating materials for window glasses of houses; paints for woodwork such as furniture; coating materials for artificial and synthetic leathers; coating materials for rubber rollers of OA devices such as copying machines and printers; coating materials for glass of reading parts of OA devices such as copying machines and scanners; optical lenses of cameras, video cameras, glasses, contact lenses, and the like and coating materials therefor; coating materials for crystals and glass of timepieces such as watches; coating materials for windows of various vehicles such as cars and railroad cars; paints for antireflective films of cover glasses and films for solar cells; paints and coating materials for FRP bathtubs; PCMs for metallic building materials and home appliances; and single-layer and multilayer coating compositions of photo fabrication processes and the like.

The polymer of the present invention has excellent surface tension lowering ability and is thus expected to have not only simply leveling properties but also functions of wettability, permeability, cleanability, water repellency, oil repellency, stain resistance, lubricity, blocking preventiveness, and mold release properties. When blended in paints or coating agents containing fine particles, the polymer of the present invention improves the dispersibility of the fine particles and is expected to have not only simply leveling properties but also functions as a dispersing agent for the fine particles. In addition to the above coating composition, when the polymer of the present invention is added to adhesive compositions for use in adhesive tapes and the like, it is expected to have not only simply leveling properties but also functions of reducing peeling force, reducing peeling force fluctuations, and reducing peeling electrification.

### [Examples]

The following specifically describes the present invention using examples and comparative examples.

The present invention is not limited to the following examples.

In the examples and the comparative examples, the weight average molecular weight (Mw) and the number average molecular weight (Mn) are values in terms of polystyrene based on gel permeation chromatography (GPC) measurement.

The GPC measurement conditions are as follows.

### [GPC Measurement Conditions]

Measurement apparatus: High-speed GPC apparatus "HLC-8420GPC" manufactured by Tosoh Corporation
Column: "TSK GUARDCOLUMN SuperHZ-L" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation.
Detector: RI (a differential refractometer)
Data processing: "EcoSEC Data Analysis version 1.07" manufactured by Tosoh Corporation
Column temperature: 40°C
Developing solvent: Tetrahydrofuran
Flow rate: 0.35 mL/minute
Sample to be measured: 7.5 mg of a sample was dissolved in 10 ml of tetrahydrofuran, and the resulting solution was filtered through a microfilter to be a sample to be measured.
Sample injection amount: 20 ul
Standard samples: The following monodisperse polystyrenes of known molecular weights were used in accordance with the measurement manual for the "HLC-8420 GPC. "

### (Monodisperse Polystyrenes)

"A-300" manufactured by Tosoh Corporation
"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation

### (Example 1: Synthesis of (Silicone/Polyester) Living Block Copolymer)

Into a flask replaced with nitrogen, 66.0 g of methyl ethyl ketone used as a solvent and 16.5 g of the polyester chain-containing monomer represented below were charged, and the temperature was raised up to 50°C while stirring the mixture under a nitrogen flow. Next, 37 g of 2,2'-bipyridyl and 1.3 g of cuprous chloride were charged thereinto, and the mixture was stirred for 30 minutes while the inside of the flask was kept at 50°C. Subsequently, 2.3 g of ethyl 2-bromoisobutyrate was added thereto, and the mixture was reacted at 50°C for 6 hours under a nitrogen flow to obtain a polymer block of ε-caprolactone-modified methacrylate.

Next, 33.5 g of 3-methacryloyloxypropyl tris(trimethylsiloxy)silane was added to the reaction system containing the polymer block of ε-caprolactone-modified methacrylate, and the mixture was reacted at 50°C for 18 hours to obtain a reaction product. Next, 30 g of activated alumina was added to the obtained reaction product, and the mixture was stirred. After filtering the activated alumina, the solvent was distilled off under reduced pressure to obtain a silicone chain-containing polymer (1). 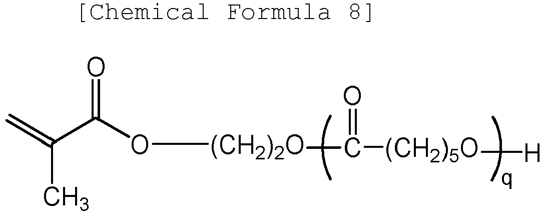 (The number average of q is 5.)

The molecular weight of the obtained silicone chain-containing polymer (1) was measured by GPC to give a weight average molecular weight (Mw) of 14,000, a number average molecular weight (Mn) of 11,000, and (Mw/Mn) of 1.2. Based on the raw material preparation ratio, the content of the functional group represented by -Si[OSi(CH₃)₃]₃ in the silicone chain-containing polymer (1) was 49% by mass.

### (Example 2: Synthesis of (Silicone/Polyester) Random Copolymer)

Into a flask replaced with nitrogen, 1,352 g of butyl acetate was charged as a solvent, and the temperature was raised up to 90°C while stirring it under a nitrogen flow. Next, a monomer polymerization initiator solution, in which 67.0 g of 3-methacryloyloxypropyl tris(trimethylsiloxy)silane, 33.0 g of the same polyester chain-containing monomer as that in Example 1, and 3.0 g of t-butylperoxy-2-ethylhexanoate used as a polymerization initiator had been dissolved in 98.1 g of butyl acetate, was set in a dropping device and was added dropwise into the flask over 2 hours while the inside of the flask was kept at 90°C. After the end of the dropwise addition, the mixture was reacted at 90°C for 7 hours under a nitrogen flow to obtain a silicone chain-containing polymer (2).

The molecular weight of the obtained silicone chain-containing polymer (2) was measured by GPC to give a weight average molecular weight (Mw) of 21,000, a number average molecular weight (Mn) of 5,800, and (Mw/Mn) of 3.5. Based on the raw material preparation ratio, the content of the functional group represented by -Si[OSi(CH₃)₃]₃ in the silicone chain-containing polymer (2) was 49% by mass.

### (Example 3: Synthesis of (Silicone/Polyester) Random Copolymer)

Into a flask replaced with nitrogen, 1,333 g of butyl acetate was charged as a solvent, and the temperature was raised up to 90°C while stirring it under a nitrogen flow. Next, a monomer polymerization initiator solution, in which 20.0 g of α-butyl-ω-(3-methacryloxypropyl)polydimethylsiloxane represented below, 80.0 g of the same polyester chain-containing monomer as that in Example 1, and 3.0 g of t-butylperoxy-2-ethylhexanoate used as a polymerization initiator had been dissolved in 1,000 g of butyl acetate, was set in a dropping device and was added dropwise into the flask over 2 hours while the inside of the flask was kept at 90°C. After the end of the dropwise addition, the mixture was reacted at 90°C for 5 hours under a nitrogen flow to obtain a silicone chain-containing polymer (3). 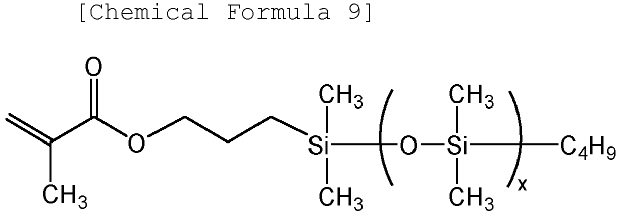 (The number average of x is 10.)

The molecular weight of the obtained silicone chain-containing polymer (3) was measured by GPC to give a weight average molecular weight (Mw) of 21,000, a number average molecular weight (Mn) of 5,800, and (Mw/Mn) of 3.5. Based on the raw material preparation ratio, the content ratio of the polymerizable unsaturated monomer having a silicone chain in the silicone chain-containing polymer (3) was 20% by mass.

Note that the value of x is a value calculated by ²⁹Si NMR analysis.

### (Comparative Example 1: Synthesis of (Silicone/Polyalkyleneoxy) Living Block Copolymer)

Into a flask replaced with nitrogen, 75.0 g of methyl ethyl ketone used as a solvent and 16.5 g of poly(1,2-butylene glycol) monomethacrylate (the number average repeat number of 1,2-butylene glycol: 6) were charged, and the temperature was raised up to 60°C while stirring the mixture under a nitrogen flow. Next, 4.2 g of 2,2'-bipyridyl and 1.5 g of cuprous chloride were charged thereinto, and the mixture was stirred for 30 minutes while the inside of the flask was kept at 60°C. Subsequently, 2.7 g of ethyl 2-bromoisobutyrate was added thereto, and the mixture was reacted at 60°C for 8 hours under a nitrogen flow to obtain a polymer block of poly(1,2-butylene glycol) monomethacrylate.

Next, 33.5 g of 3-methacryloyloxypropyl tris(trimethylsiloxy)silane was added to the reaction system containing the polymer block of poly(1,2-butylene glycol) monomethacrylate, and the mixture was reacted at 60°C for 20 hours to obtain a reaction product. Next, 30 g of activated alumina was added to the obtained reaction product, and the mixture was stirred. After filtering the activated alumina, the solvent was distilled off under reduced pressure to obtain a silicone chain-containing polymer (1').

The molecular weight of the obtained silicone chain-containing polymer (1') was measured by GPC to give a weight average molecular weight (Mw) of 10,300, a number average molecular weight (Mn) of 7,900, and (Mw/Mn) of 1.3. Based on the raw material preparation ratio, the content of the functional group represented by -Si[OSi(CH₃)₃]₃ in the silicone chain-containing polymer (1') was 49% by mass.

### (Comparative Example 2: Synthesis of (Silicone/Polyalkyleneoxy) Random Copolymer)

Into a flask replaced with nitrogen, 133.3 g of butyl acetate was charged as a solvent, and the temperature was raised up to 100°C while stirring it under a nitrogen flow. Next, a monomer polymerization initiator solution, in which 67.0 g of 3-methacryloyloxypropyl tris(trimethylsiloxy)silane, 33.0 g of poly(1,2-butylene glycol) monomethacrylate (the average repeat number of 1,2-butylene glycol: 6), and 6.0 g of t-butylperoxy-2-ethylhexanoate used as a polymerization initiator had been dissolved in 1,000 g of butyl acetate, was set in a dropping device and was added dropwise into the flask over 3 hours while the inside of the flask was kept at 100°C. After the end of the dropwise addition, the mixture was reacted at 100°C for 5 hours under a nitrogen flow to obtain a silicone chain-containing polymer (2').

The molecular weight of the obtained silicone chain-containing polymer (2') was measured by GPC to give a weight average molecular weight (Mw) of 6,000, a number average molecular weight (Mn) of 2,500, and (Mw/Mn) of 2.4. Based on the raw material preparation ratio, the content of the functional group represented by -Si[OSi(CH₃)₃]₃ in the silicone chain-containing polymer (2') was 49% by mass.

### (Comparative Example 2: Synthesis of (Silicone/Polyalkyleneoxy) Random Copolymer)

Into a flask replaced with nitrogen, 133.3 g of butyl acetate was charged as a solvent, and the temperature was raised up to 110°C while stirring it under a nitrogen flow. Next, a monomer polymerization initiator solution, in which 30.0 g of the same α-butyl-ω-(3-methacryloxypropyl)polydimethylsiloxane as that in Example 3, 70.0 g of poly(1,2-butylene glycol) monomethacrylate (the number average repeat number of 1,2-butylene glycol: 6), and 7.5 g of t-butylperoxy-2-ethylhexanoate used as a polymerization initiator had been dissolved in 100.0 g of butyl acetate, was set in a dropping device and was added dropwise into the flask over 2 hours while the inside of the flask was kept at 110°C. After the end of the dropwise addition, the mixture was reacted at 110°C for 3 hours under a nitrogen flow to obtain a silicone chain-containing polymer (3').

The molecular weight of the obtained silicone chain-containing polymer (3') was measured by GPC to give a weight average molecular weight (Mw) of 5,000, a number average molecular weight (Mn) of 2,000, and (Mw/Mn) of 2.5. Based on the raw material preparation ratio, the content ratio of the polymerizable unsaturated monomer having a silicone chain in the silicone chain-containing polymer (3') was 29% by mass.

### (Formation and Evaluation of Coating Film)

A coating film was formed as follows using the silicone chain-containing polymer (1) produced in Example 1.

Mixed together were 3.0 g of a resin solution with 40% by mass of an alkali-soluble resin (Acrydic ZL-295, manufactured by DIC Corporation), 1.2 g of Aronix M-402 (manufactured by Toagosei Co., Ltd., a mixture of dipentaerythritol pentaacrylate and dipentaerythritol hexaacrylate), 0.001 g of the silicone chain-containing polymer (1) in terms of solid content, and 3.8 g of propylene glycol monomethyl ether acetate (PGMEA) to prepare a composition.

The obtained composition in an amount of 3 ml was dropped onto the central part of a 10 cm × 10 cm chrome-plated glass substrate, was spin coated under conditions of a number of revolutions of 1,000 rpm and a time of revolutions of 10 seconds, and was then heat-dried at 100°C for 100 seconds to produce a laminate having a coating film layer.

For the coating film layer of the produced laminate, its smoothness and coating film defects were evaluated by the following method. Table 1 lists the results.

### (Smoothness)

The coating film layer of the obtained laminate was visually observed and was evaluated for the smoothness of the coating film layer in accordance with the following criteria.
AA: No coating film unevenness is not observed.
A: Almost no coating film unevenness is observed.
B: Coating film unevenness is partially observed.
C: Coating film unevenness is observed throughout.

The same evaluation as in Example 1 was performed except that the polymers produced in Examples 2 and 3 and Comparative Examples 1 to 3 were each used instead of the silicone chain-containing polymer (1). Table 1 lists the results.

**[Table 1]**

| | Exampl e 1 | Exampl e 2 | Exampl e 3 | Comparativ e Example 1 | Comparativ e Example 2 | Comparativ e Example 3 |
|---|---|---|---|---|---|---|
| Monomer | Silico ne polyes ter | Silico ne polyes ter | Silico ne polyes ter | Silicone polyalkyle neoxy | Silicone polyalkyle neoxy | Silicone polyalkyle neoxy |
| Polymeriz ation type | Block | Random | Random | Block | Random | Random |
| Smoothnes s | AA | A | AA | B | C | C |

As indicated in the results in Table 1, it can be seen that the compositions of Examples 1 to 3, which each contain the copolymer of the polymerizable monomer having a silicone group and the polymerizable monomer having a polyester chain, have excellent smoothness of the coating film. On the other hand, it can be seen that the compositions of Comparative Examples 1 to 3, which each contain the copolymer having a silicone group but having no polyester chain, have insufficient smoothness of the coating film.

## Claims

1. A silicone chain-containing polymer comprising, as a polymeric component, at least a polymerizable monomer (1) having a group represented by General Formula (A) below and a polymerizable monomer (2) having a group containing a polyester chain: 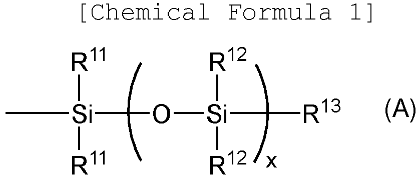 in General Formula (A) above,
R¹¹ are each independently a C₁₋₆ alkyl group or a group represented by -OSi(R¹⁴)₃ (R¹⁴ are each independently a C₁₋₃ alkyl group),
R¹² are each independently a C₁₋₆ alkyl group,
R¹³ is a C₁₋₆ alkyl group, and
x is an integer of 0 or more.

2. The silicone chain-containing polymer according to claim 1, wherein the group containing a polyester chain is a group represented by General Formula (B-1) below or a group represented by General Formula (B-2) below: 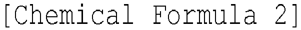 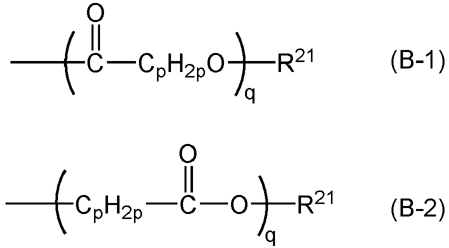 in General Formulae (B-1) and (B-2) above,
R²¹ is a hydrogen atom, a C₁₋₁₈ alkyl group, or a C₁₋₁₈ alkyl group having an ether bond,
p is an integer in a range of 1 to 30, and q is an integer of 2 or more.

3. The silicone chain-containing polymer according to claim 1 or 2, wherein the polymerizable monomer (1) is a compound represented by General Formula (1-1) below: 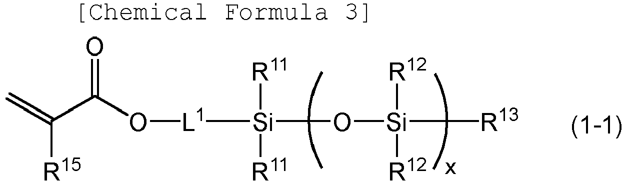 in General Formula (1-1) above,
R¹¹, R¹², R¹³, and x are same as R¹¹, R¹², R¹³ and x in General Formula (A) above, respectively,
R¹⁵ is a hydrogen atom or a methyl group, and
L¹ is a divalent organic group or a single bond.

4. The silicone chain-containing polymer according to any of claims 1 to 3, wherein the polymerizable monomer (2) is a compound represented by General Formula (2-1) below or a compound represented by General Formula (2-2) below: 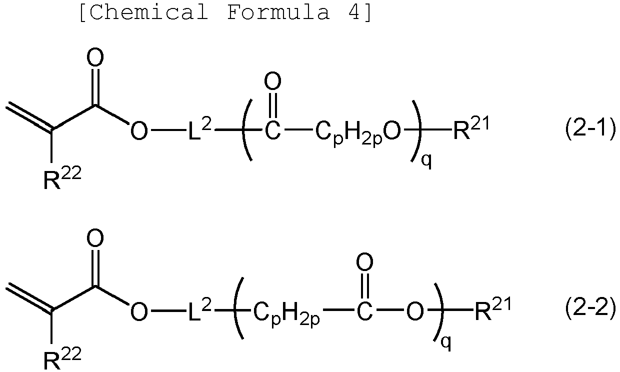 in General Formulae (2-1) and (2-2) above,
R²¹, p, and q are same as R²¹, p, and q in General Formulae (B-1) and (B-2) above, respectively,
L² is a divalent organic group or a single bond, and
R²² is a hydrogen atom or a methyl group.

5. The silicone chain-containing polymer according to any of claims 1 to 4, having a number average of x in the silicone chain-containing polymer in a range of 1 to 150.

6. The silicone chain-containing polymer according to any of claims 1 to 5, further comprising, as the polymeric component, a polymerizable monomer (3) having one or more selected from a C₁₋₁₈ alkyl group, a C₆₋₁₈ aromatic group, and a group containing a polyoxyalkylene chain.

7. The polymer according to claim 6, wherein the polymerizable monomer (3) is a compound represented by General Formula (3-1) below or a compound represented by General Formula (3-2) below: 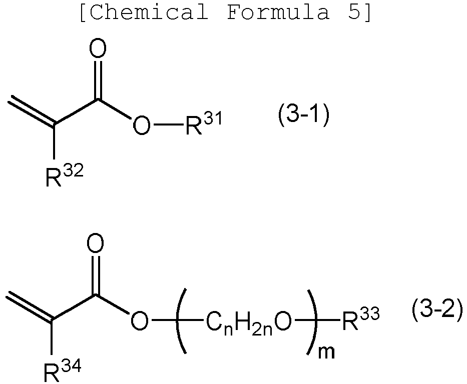 in General Formulae (3-1) and (3-2) above,
R³¹ is a C₁₋₁₈ alkyl group,
R³² is a hydrogen atom or a methyl group,
R³³ is a hydrogen atom or a C₁₋₁₈ alkyl group,
R³⁴ is a hydrogen atom or a methyl group,
n is an integer in a range of 1 to 4, and m is an integer in a range of 1 to 200.

8. The silicone chain-containing polymer according to any of claims 1 to 7, containing the polymerizable monomer (1) in a range of 5 to 75% by mass of the polymeric component.

9. The silicone chain-containing polymer according to any of claims 1 to 8, wherein the polymerizable monomer (1) and the polymerizable monomer (2) amount to 80% by mass or more of the polymeric component.

10. The silicone chain-containing polymer according to any of claims 1 to 9, not containing any fluorine atoms.

11. The silicone chain-containing polymer according to any of claims 1 to 10, having a number average molecular weight in a range of 1,000 to 500,000.

12. A coating composition comprising the silicone chain-containing polymer according to any of claims 1 to 11.

13. A resist composition comprising the silicone chain-containing polymer according to any of claims 1 to 11.

14. An article comprising the silicone chain-containing polymer according to any of claims 1 to 11.
